# EUROPÄISCHE PATENTSCHRIFT

(11) **EP 2 129 811 B1**
(45) Veröffentlichungstag und Bekanntmachung des Hinweises auf die Patenterteilung: **28.08.2013**
(21) Anmeldenummer: 07846914.5
(22) Anmeldetag: 30.11.2007
(51) Int. Cl.: C23C 14/56, C23C 14/24

(54) **LAUFENDE BESCHICHTUNG**
CONTINUOUS COATING
REVÊTEMENT CONTINU

(30) Priorität: 30.11.2006 DE 102006056984
(43) Veröffentlichungstag der Anmeldung: 09.12.2009
(73) Patentinhaber: Leybold Optics GmbH, 63755 Alzenau (DE)
(72) Erfinder: STEPHAN, Küper, 61352 Bad Homburg (DE)
(74) Vertreter: Pohlmann, Bernd Michael
(86) Internationale Anmeldenummer: PCT/EP2007/010389
(87) Internationale Veröffentlichungsnummer: WO 2008/064894

(56) Entgegenhaltungen:
- EP-A- 1 408 135
- EP-B- 0 474 964
- DE-A1-102004 047 938

## Beschreibung

Die Erfindung betrifft eine Vorrichtung und ein Verfahren jeweils gemäß den Oberbegriffen der unabhängigen Patentansprüche.

Zur Metallbeschichtung von bandförmigen Substraten ist die Verwendung von eine Verdampferbank bildenden Beschichtungsquellen bekannt. Die Beschichtungsquellen haben häufig eine längliche Form und werden dann als Verdampferschiffchen bezeichnet. Das verdampfende Material, vorzugsweise Aluminium, bildet eine Dampfkeule mit einer charakteristischen Intensitätsverteilung bzw. Emissionscharakteristik des verdampften Materials über den einzelnen Verdampferschiffchen. Bei typischen Vorrichtungen zur Bandbeschichtung wird das bandförmige Substrat von einer Abwickelrolle abgewickelt und einer Aufwickelrolle zugeführt und dabei in einem Bereich oberhalb der Verdampferbank bewegt, so dass die nach unten gerichtete Seite des Substrats mit in den Verdampferschiffchen verdampften Metall beschichtet wird.

Eine spezielle Vorrichtung zur laufenden Beschichtung von bandförmigen Substraten ist auf der DE 40 27 034 C1 sowie der EP 0474964 B1 bekannt. Danach ist eine Vielzahl von - eine Verdampferbank bildenden, längs zur Banklaufrichtung und parallel in etwa gleichen Abständen zueinander angeordneten Verdampferschiffchen etwa gleicher Größe und Konfiguration vorgesehen. Die Verdampferschiffchen sind sämtlich aus einer elektrisch leitenden Keramik gebildet und durch direkten Stromdurchgang beheizbar. Ferner ist eine Vorrichtung für die kontinuierliche Zuführung von zu verdampfendem Draht zu den Verdampferschiffchen vorgesehen. Die einzelnen parallel zu einander oder zur Bandlaufrichtung liegenden Verdampferschiffchen der Verdampferbank sind jeweils versetzt zueinander angeordnet, wobei alle Verdampferschiffchen gemeinsam eine schmale Beschichtungszone überdecken, die sich quer zur Bandlaufrichtung erstreckt.

Es ist, unter anderem aus den Dokumenten DE 40 27 034 C1 und EP 047 49 64 B1 bekannt, dass durch die Überlagerung der Dampfkeulen der Einzelquellen eine ungleichmäßige Schichtverteilung auf dem zu beschichtenden Band entsteht. Im Idealfall ist dies eine wellenförmige Verteilung mit Maxima beziehungsweise Minima über beziehungsweise zwischen den Verdampferschiffchen. Die bestenfalls erreichbare Schichtgleichmäßigkeit wird bestimmt durch die Amplitude von Maxima und Minima, wobei die Amplitude abhängig von der geometrischen Anordnung und der Emissions-Charakteristik der einzelnen

Verdampferschiffchen sowie von der Wechselwirkung der Dampfkeulen der Verdampferschiffchen untereinander ist. Zur Verbesserung der Schichtdickengleichmäßigkeit

bei parallel zueinander angeordneten einzelnen Verdampferschiffchen der Verdampferbank wird in den genannten Dokumenten vorgeschlagen, die Verdampferschiffchen zueinander versetzt anzuordnen, so dass diese gemeinsam eine schmale Beschichtungszone abdecken. Dabei tritt allerdings ein Wirkungsgradverlust bei der Beschichtung auf.

In EP 1 408 135 A1 werden die Verdampferschiffchen in einem Winkel zur Laufrichtung des Substrats angeordnet.

Der vorliegenden Erfindung liegt die Aufgabe zugrunde, eine weitere und bessere Möglichkeit zu schaffen, bei einer Beschichtung eines bandförmigen Substrats mittels eine Verdampferbank bildenden Verdampferschiffchen eine höhere Beschichtungsgleichmäßigkeit zu erreichen.

Die genannte Aufgabe wird erfindungsgemäß durch die Merkmale der unabhängigen Ansprüche gelöst. Besondere Ausführungsarten sind in den abhängigen Ansprüchen angegeben.

Es ist vorgesehen, dass die Verdampferbank durch eine Menge A und eine Menge B von Verdampferschiffchen gebildet wird. Während der Beschichtung ist das bandförmige Substrat in einer Laufrichtung X senkrecht zu einer Richtung Y bewegbar. Die Menge A der Verdampferschiffchen weist eine Länge LA in einem Bereich zwischen L0 - δ A und L0 + δ A auf, während die Verdampferschiffchen der Menge B eine Länge LB in einem Bereich zwischen L0 - δ B und L0 + δ B aufweisen. Die Verdampferschiffchen der Menge A und der Menge B sind innerhalb einer sich parallel zur Y Richtung erstreckenden Zone mit einer Breite in X-Richtung von höchstens 2 L0 + δ A + δ B angeordnet.

Die Verdampferschiffchen der Menge A sind jeweils in einem Winkel α in einem Bereich zwischen -2° und -10° relativ zur Richtung X angeordnet, wobei der Winkel in Uhrzeigerrichtung orientiert ist. Die Verdampferschiffchen der Menge B sind jeweils in einem Winkel β in einem Bereich zwischen 2° und 10° relativ zur Richtung X angeordnet, wobei der Winkel in Uhrzeigerrichtung orientiert ist Die Verdampferschiffchen der Menge A und der Menge B sind alternierend nebeneinander angeordnet und bilden anschaulich gesprochen ein Fischgrätenmuster. Die Verdampferschiffchen der Menge A sowie die der Menge B weisen demnach jeweils eine Abweichung von der Parallelität zur Laufrichtung X auf. Ferner sind die Verdampferschiffchen der Menge A jeweils relativ zu den Verdampferschiffchen der Menge B verdreht.

Überraschenderweise gelingt es, mit diesen gezielten Abweichungen von einer Parallelität der Verdampferschiffchen gegenüber der Laufrichtung X sowie der gegenseitigen Orientierung eine höhere Schichtgleichmäßigkeit zu erzielen, als mit Verdampferschiffchen, die parallel zur Laufrichtung X sowie parallel zueinander angeordnet sind. Zum Verständnis dieser Ergebnisse wurden Simulationsrechnungen durchgeführt. Bei den Simulationsrechnungen wurde davon ausgegangen, dass die Dampfkeule eines einzelnen Verdampferschiffchens eine gaussähnliche oder cosⁿ Intensitätsverteilung quer zur Längsachse eines Verdampferschiffchens aufweist. Eine derartige Intensitätsverteilung wurde beispielsweise in dem Artikel von Susaki und Ikarashi (AIMCAL Fall Technical Conference, Reno, 22. -25.10.2006 Vacuum Webcoating Sessions, Session 2 B, Figure 8) beschrieben.

Bei einer gaussähnlichen oder cos" Intensitätsverteilung weisen die Dampfkeulen Schenkel auf. Es ist bei einer Vielzahl von Verdampferschiffchen von einer Wechselwirkung der Dampfkeulen dahingehend auszugehen, dass die Intensitätsverteilung schmaler und schärfer wird, je mehr Wechselwirkung die Dampfkeulen untereinander haben. Bei einer Anordnung der Schiffchen parallel zur Bandlaufrichtung deuten die Schenkel der Dampfkeulen jeweils auf das Zentrum größter Intensität des nächsten Schiffchens der Teilmenge A oder B. Dies dürfte zu einer Einengung der Verteilung führen. Bei einer erfindungsgemäßen Verdrehung der Verdampferschiffchen zeigt ein Schenkel ins Freie, während der andere Schenkel zwischen den Dichtezentren der benachbarten Schiffchen hindurch zeigt. In beiden Fällen ist eine geringere Wechselwirkung der Dampfkeulen zu erwarten. Aufgrund der Simulationsrechnungen ist zu vermuten, dass die Verringerung der Schichtdickenschwankung darauf zurückzuführen ist, dass die Variation der Intensitätsverteilung der überlagerten Dampfkeulen der in der Verdampferbank angeordneten Verdampferschiffchen geringer wird, da die Intensitätsverteilung der einzelnen Schiffchen insgesamt breiter geworden ist.

Die bevorzugten Werte der Winkel α und β sind abhängig von der geometrischen Anordnung der Verdampfungsschiffchen sowie der Dampfkeulenform, also der charakteristischen Intensitätsverteilung über den Verdampferschiffchen.

Bei einer besonders einfachen Ausführungsform sind die Beträge der Winkel aller Verdampferschiffchen der Menge A und/oder B jeweils gleich groß.

Ferner hat sich gezeigt, dass es vorteilhaft ist, wenn die Summe der Winkel α und β = 0° ist.

Konstruktive Vorteile ergeben sich, wenn die Verdampferschiffchen der Menge A die Länge L0 aufweisen und/oder die Verdampferschiffchen der Menge B jeweils die Länge L0 aufweisen. In einer weiteren Ausbildungsform der Erfindung sind die Verdampferschiffchen der Menge A in einem Streifen SA und/oder die Verdampferschiffchen der Menge B in einem Streifen SB angeordnet wobei die Streifen SA und SB eine Überlappzone Z aufweisen. Die Verdampferschiffchen der Menge A und/oder der Menge B werden damit geometrisch zusammengefasst, wodurch die Wahl geeigneter Werte für die Winkel a und β erleichtert wird. Die Streifen SA und SB können jeweils konstante Breite BA und BB aufweisen. Günstigerweise können die Streifen SA und SB gleiche Breite aufweisen. Besonders günstig ist es, wenn die Streifen SA und SB jeweils parallel zur Richtung Y, also senkrecht zur Laufrichtung X angeordnet sind.

Die Überlappzone Z kann kleiner oder gleich der Breite des schmalsten der Streifen SA und SB sein.

Bei einer bevorzugten Ausführungsform weisen sämtliche Verdampferschiffchen die Länge L0, die Winkel der Verdampferschiffchen der Menge A gleich α, die Winkel der Verdampferschiffchen der Menge B gleich β und die Streifen SA und SB gleiche konstante Breite B auf. Ferner können die Streifen SA und SB parallel zur Y Richtung angeordnet sein.
In diesem Fall liegen gleichartige geometrische Punkte der Verdampferschiffchen der Menge A jeweils auf einer Geraden parallel zur Richtung Y, während die gleichartigen geometrischen Punkte der Verdampferschiffchen der Menge B auf einer parallel zu dieser Geraden verschobenen Geraden angeordnet sind. Gleichartige geometrische Punkte sind beispielsweise Eckpunkte oder Mittelpunkte der Verdampferschiffchen. Bevorzugt ist eine Überlappzone Z mit einer Breite BZ in einem Bereich zwischen 0.1B und 0.95B, besonders bevorzugt zwischen 0.6B und 0.8B. Hiermit kann eine weitere Reduktion der Schichtdickenschwankung erreicht werden.

Vorzugsweise haben die Verdampferschiffchen der Menge A und/oder der Menge B bezogen auf gleichartige geometrische Punkte der Verdampferschiffchen gleichen Abstand voneinander. Es versteht sich, dass auch unterschiedliche Abstände vorgesehen sein können.

Erfindungsgemäß können für die Winkel α und β optimale Werte gewählt sein, sodass der Wert einer Schichtdickenschwankung (Dmax - Dmin): (Dmax + Dmin) minimal ist.

Die Aufgabe wird ferner durch ein Verfahren gemäß Anspruch 12 gelöst, wobei das Substrat während der Beschichtung in einer Laufrichtung X senkrecht zu einer Richtung Y bewegbar ist, mit einer Anzahl von Verdampferschiffchen, die eine Verdampferbank bilden, wobei die Anzahl der Verdampferschiffchen von einer Menge A und einer Menge B von Verdampferschiffchen gebildet wird, die Verdampferschiffchen der Menge A eine Länge LA in einem Bereich zwischen L0 - δ A und L0 + δ A aufweisen, die Verdampferschiffchen der Menge B eine Länge LB in einem Bereich zwischen L0 - δ B und L0 + δ B aufweisen und die Anzahl der Verdampferschiffchen innerhalb eines sich parallel zur Richtung Y erstreckenden Bereichs mit einer Breite von höchstens 2 L0 + δ A + δ B in X-Richtung angeordnet sind. Dabei ist vorgesehen, dass die Verdampferschiffchen der Menge A und der Menge B alternierend nebeneinander und die Verdampferschiffchen der Menge A jeweils in einem Winkel α in einem Bereich zwischen **-2°** und -10° relativ zur Richtung X und die Verdampferschiffchen der Menge B jeweils in einem Winkel β zwischen 2° und 10° relativ zur Richtung X angeordnet werden.

Weitere vorteilhafte Ausführungsformen der Erfindung sind auch unabhängig von ihrer Zusammenfassung in den Ansprüchen den nachfolgenden Zeichnungen sowie der zugehörigen Beschreibung zu entnehmen.

Es zeigen:
- Figur 1: eine schematische Darstellung einer Vorrichtung zur Beschichtung eines bandförmigen Substrats
- Figur 2: eine schematische Darstellung einer erfindungsgemäßen Anordnung von Verdampferschiffchen in Obenansicht
- Figur 3: eine schematische Darstellung von Dampfkeulen von Verdampferschiffchen
- Figur 4: Ergebnisse einer Simulationsrechnung von Schichtdickenänderungen von parallel versetzt und erfindungsgemäß angeordneten Verdampferschiffchen.

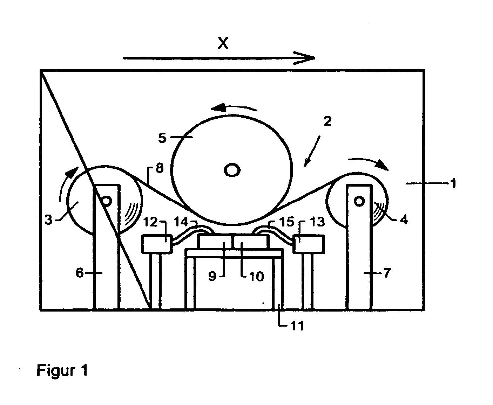

In Fig. 1 ist in schematischer Seitenansicht eine Vakuumkammer 1 mit einer Beschichtungsanlage 2 dargestellt. Die Beschichtungsanlage weist eine Abwickelrolle 3, eine Aufwickelrolle 4 sowie eine Beschichtungstrommel 5 auf. Die Ab-, Aufwickelrollen 3, 4 sind auf Ständern 6, 7 gelagert. Ein entsprechender Ständer der Beschichtungstrommel 5 ist in Figur 1 nicht dargestellt. Die Abwickelrolle 3 wird gebildet von einem aufgewickelten bandförmigen Substrat 8, beispielsweise einer Folie. Das Substrat 8 wird in Laufrichtung X zur Aufwickelrolle 4 hin abgewickelt und von der Beschichtungstrommel 5 geführt. Unterhalb der Beschichtungstrommel 5 sind Verdampferschiffchen 9, 10 dargestellt, die auf einem Tisch 11 angeordnet sind. Seitlich neben den Verdampferschiffchen 9, 10 sind Einrichtungen 12, 13 dargestellt, die Drähte eines zu verdampfenden Materials 14, 15 in den Bereich der Verdampferschiffchen 9, 10 führen. Die Verdampferschiffchen 9, 10 werden mittels einer nicht dargestellten Heizeinrichtung aufgeheizt, so dass die Drähte in oder auf den Verdampferschiffchen 9, 10 verdampfen. Das verdampfte Material schlägt sich auf der nach unten gerichteten Seite der Folie 8 nieder.

Die Verdampferschiffchen 9, 10 weisen vorzugsweise eine rechteckförmige Gestalt auf, bestehen vorzugsweise aus temperaturfester Keramik und können auf ihrer Oberfläche eine als Kavität bezeichnete Vertiefung aufweisen. Ferner sind auch Verdampferschiffchen ohne Kavität bekannt. Die Oberfläche kann ferner zusätzlich Riffelungen oder andere Strukturen aufweisen. Als Material der zu verdampfenden Drähte kommt insbesondere Aluminium in Betracht.

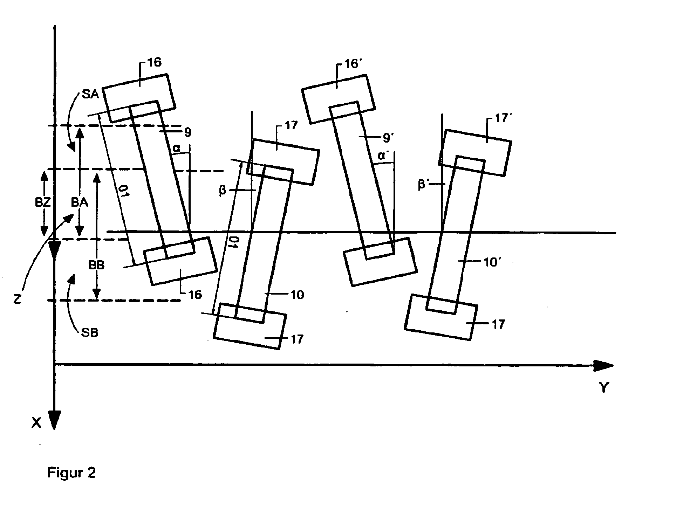

In Fig. 2 sind in Obenansicht rechteckförmige Verdampferschiffchen 9, 9' und 10, 10' dargestellt, die einen Teil einer Verdampferbank bilden. Die Verdampferschiffchen 9, 9', 10, 10' sind mittels Befestigungsteilen 16, 16', 17, 17' in vorgegebenen Positionen gegenüber der Laufrichtung X sowie der senkrecht auf der Richtung X stehenden Richtung Y angeordnet. Die Verdampferschiffchen 9, 9' und 10, 10' in Figur 2 weisen sämtlich die gleiche Länge L0 auf. Die Verdampferschiffchen 9 und 9' sind jeweils mit einem Winkel α beziehungsweise α' in einem Bereich zwischen -2° und -10° zur Richtung X angeordnet. Die Verdampferschiffchen 10 und 10' sind mit einem Winkel β beziehungsweise β' in einem Bereich zwischen 2° und 10° zur Richtung X angeordnet. Anschaulich gesprochen, bilden die Verdampferschiffchen in Figur 2 ein Fischgrätenmuster.

Während in der Darstellung der Figur 2 lediglich vier Verdampferschiffchen gezeigt sind, versteht es sich, dass die Erfindung 8 Verdampferbänke mit einer Vielzahl von Verdampferschiffchen umfasst. Ferner kann die Länge der Verdampferschiffchen unterschiedlich sein.

Erfindungsgemäß bilden die Verdampferschiffchen eine Menge A und eine Menge B , wobei die Elemente der Menge A eine Länge LA in einem Bereich zwischen L0 - δ A und LO+ δ A und die Elemente der Menge β eine Länge LB in einem Bereich zwischen L0 - δ B und L0 + δ B liegen. Die Schiffchen der Menge A weisen gegenüber der Y Richtung einen Winkel α in einem Bereich zwischen -2° und -10°, die Verdampferschiffchen der Menge B einen Winkel β in einem Bereich zwischen 2° und 10° auf. Die Verdampferschiffchen der Menge A und B sind in einem Bereich mit einer maximalen Breite von 2 L0 + δ A + δ B angeordnet. Figur 2 entspricht der Situation mit δ A = δ B = 0.

Die erfindungsgemäße Anordnung der Verdampferschiffchen in einem Fischgrätenmuster erlaubt es die Schichtdickenschwankung (Dmax - Dmin) : (Dmax + Dmin) gegenüber bekannten Anordnungen von Verdampferschiffchen zu reduzieren, wobei Dmax die maximale und Dmin die minimale Schichtdicke eines beschichteten Substrats bezeichnet.

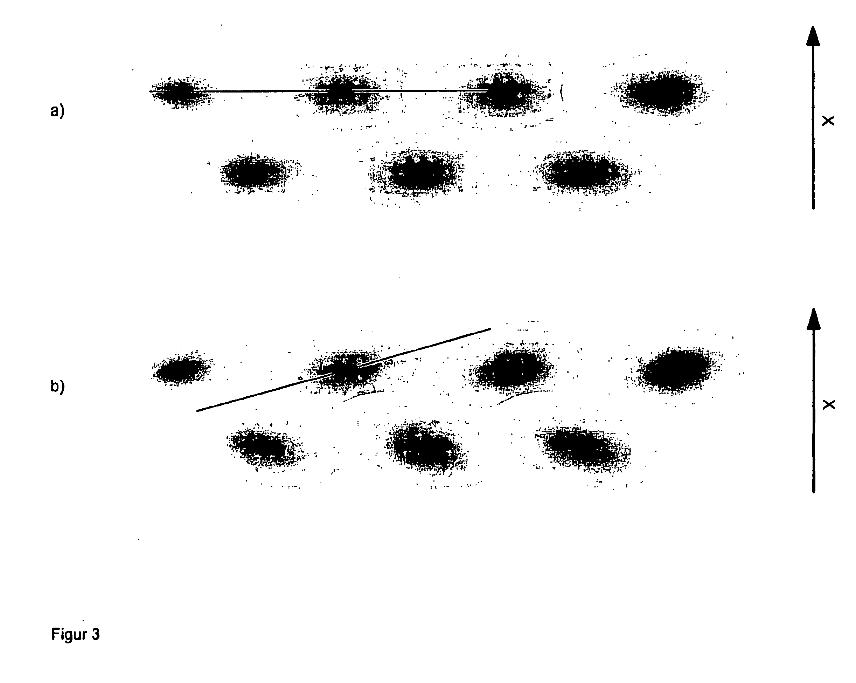

Figur 3 zeigt in Gegenüberstellung die Intensitätsverteilung von verdampften Material in einem Bereich oberhalb einer konventionellen Anordnung von Verdampferschiffchen, Figur 3a, und einer erfindungsgemäßen Anordnung von Verdampferschiffchen, Figur 3b. Die Verdampferschiffchen sind jeweils rechteckförmig mit einer Längsachse. Die Figur 3a entspricht parallel zueinander und zur Laufrichtung X eines Substrats angeordneten, relativ zueinander versetzten rechteckförmigen Verdampferschiffchen. Die Figur 3b entspricht einer Anordnung von Verdampferschiffchen, die um einen Winkel von -5° beziehungsweise 5° zur Laufrichtung X angeordnet sind. Für die individuellen Verdampferschiffchen wurde dabei eine gauss- oder cosⁿ-förmige Intensitätsverteilung oder Dampfkeule mit Maxima im Wesentlichen senkrecht zur Längsachse der Verdampferschiffchen angenommen. Zur Vereinfachung wurde in der Darstellung der Figur 3 in den Überlagerungsbereichen der Dampfkeulen lediglich die zu einem Verdampferschiffchen gehörige Intensitätsverteilung dargestellt. Die in Figur 3a dargestellte Gerade zwischen den Zentren von drei Dampfkeulen illustriert, dass Bereiche mit hoher Intensität überlappen. In Figur 3b ist zu erkennen, dass im Innenbereich der Verteilung eine Überlappung von Bereichen mit geringerer Intensität erfolgt und im Außenbereich überlappungsfreie Bereiche auftreten, so dass die Verteilung insgesamt breiter wird als im Fall der Figur 3a. Die Simulation zeigt, dass bereits geringe Änderungen der Breite der Verteilungen erhebliche Änderungen der Schichtdickenschwankung bewirken können.

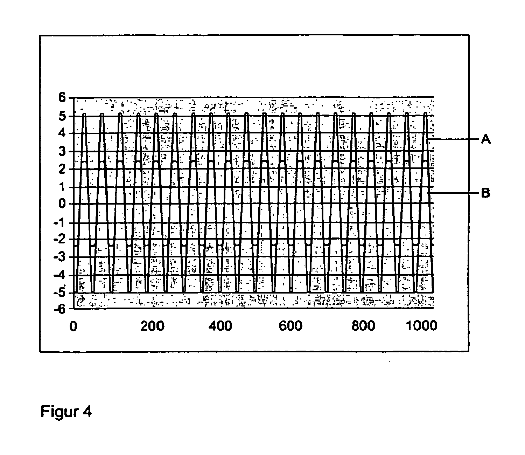

Für Figur 3a und 3b entsprechende Anordnungen von Verdampferschiffchen wurden in Simulationsrechnungen die resultierenden Schichtdickenschwankungen berechnet. Figur 4 zeigt die Ergebnisse der Simulationsrechnungen, wobei die Kurve A der Anordnung der Figur 3a und die Kurve B der Anordnung der Figur 3b entspricht, jeweils mit 22 geometrisch gleichen Verdampferschiffchen, d.h. gleicher Länge und Form. Für die Intensitätsverteilung wurde eine gaussähnliche Form gewählt. Die Abszisse entspricht dabei einer Position senkrecht zur Laufrichtung X, die Ordinate gibt die Schichtdickenschwankung in Prozent an. Bei der Simulationsrechnung wurden die Parameter für die Anordnung gemäß 3a so gewählt, dass eine Schichtdickenschwankung von +/- 5 % um einen Mittelwert resultierte.

Wie in Figur 4 dargestellt ist, findet man bei einer erfindungsgemäßen Anordnung mit gleichen Parametern wie denen der konventionellen Anordnung in Figur 3a, allerdings mit um -5° beziehungsweise 5° zur Laufrichtung X verdrehten Verdampferschiffchen eine Schichtdickenschwankung von nur +/- 2,5 %. Ähnliche Verbesserungen ergaben sich bei cos"-förmigen Intensitätsverteilungen und bei realen Beschichtungsexperimenten.

## Patentansprüche

1. Vorrichtung zur Beschichtung eines bandförmigen Substrats (8), welches in einer Laufrichtung (X) gegenüber einer Verdampferbank bewegbar ist, wobei
- die Verdampferbank eine Anzahl beheizbarer Verdampferschiffchen (9, 9', 10, 10') aufweist, wobei die Längsachsen der Verdampferschiffchen gegenüber der Laufrichtung (X) einen Winkel (a, a', β, β') einschließen,
- die Vorrichtung eine Einrichtung (12,13) zur Zuführung von Draht eines zu verdampfenden Materials (14, 15) zu den Verdampferschiffchen (9, 9', 10, 10') aufweist,
**dadurch gekennzeichnet, dass**
- besagter Winkel (α, α', β, β') einen Absolutbetrag zwischen 2° und 10° aufweist,
- die Verdampferschiffchen (9, 9', 10, 10') alternierend nebeneinander angeordnet sind, so dass ein Verdampferschiffchen (9, 9'), dessen Längsachse gegenüber der Laufrichtung (X) entgegen dem Uhrzeigersinn gedreht ist, sich neben einem Verdampferschiffchen (10, 10') befindet, dessen Längsachse gegenüber der Laufrichtung (X) im Uhrzeigersinn gedreht Ist.

2. Vorrichtung nach Anspruch 1, **dadurch gekennzeichnet, dass** die Dampfkeule eines einzelnen Verdampferschiffchens (9, 9', 10, 10') ein Dichtezentrum mit Schenkeln quer zur Längsachse des Verdampferschiffchens (9, 9', 10, 10') aufweist, für eine Vielzahl von Verdampferschiffchen (9, 9', 10, 10') ein Schenkel ins Freie zeigt, während der andere Schenkel zwischen den Dichtezentren der benachbarten Verdampferschiffchen hindurch zeigt.

3. Vorrichtung nach einem der vorhergehenden Ansprüche, **dadurch gekennzeichnet, dass** die Absolutbeträge der Winkel (a, a') der entgegen dem Uhrzeigersinn gedrehten Verdampferschiffchen (9, 9') oder die Absolutbeträge der Winkel (β, β') der im Uhrzeigersinn gedrehten Verdampferschiffchen (10, 10') in einem Bereich zwischen 3° und 10° liegen.

4. Vorrichtung nach einem der vorhergehenden Ansprüche, **dadurch gekennzeichnet, dass** die Absolutbeträge der Winkel (a, α', β, β') aller Verdampferschiffchen (9, 9', 10, 10') in einem Bereich zwischen 3° und 10° liegen.

5. Vorrichtung nach einem der vorhergehenden Ansprüche, **dadurch gekennzeichnet, dass** die Winkel (α, α', β, β') der Verdampferschiffchen (9, 9', 10, 10') den näherungsweise gleichen Absolutbetrag haben.

6. Vorrichtung nach Anspruch 5, **dadurch gekennzeichnet, dass** die Absolutbeträge der Winkel (α, α', β, β') der Verdampferschiffchen (9, 9', 10, 10') näherungswelse 5° betragen.

7. Vorrichtung nach einem der vorhergehenden Ansprüche, **dadurch gekennzeichnet,**
- **dass** die entgegen dem Uhrzeigersinn gedrehten Verdampferschiffchen (9, 9') innerhalb eines Streifens (SA) angeordnet sind,
- **dass** die im Uhrzeigersinn gedrehten Verdampferschiffchen (10, 10') innerhalb eines Streifens (SB) angeordnet sind,
- und **dass** die Streifen (SA, SB) eine Überlappzone (Z) aufweisen.

8. Vorrichtung nach Anspruch 7, **dadurch gekennzeichnet, dass** jeder Streifen (SA,SB) eine konstante Breite (BA, BB) aufweist.

9. Vorrichtung nach Anspruch 7 oder 8, **dadurch gekennzeichnet, dass** die Streifen (SA, SB) senkrecht zur Laufrichtung (X) angeordnet sind.

10. Vorrichtung nach einem der vorhergehenden Ansprüche, **dadurch gekennzeichnet, dass** die Winkel (α, α', β, β') in einer solchen Weise gewählt sind, dass die durch die Verdampferbank auf dem Substrat (8) bewirkte Beschichtung eine minimale Schichtdickenschwankung aufweist.

11. Verfahren zur Beschichtung eines bandförmigen Substrats (8), welches in einer Laufrichtung (X) gegenüber einer Verdampferbank bewegt wird, wobei
- die Verdampferbank eine Anzahl beheizbarer Verdampferschiffchen (9, 9', 10, 10') aufweist, wobei die Längsachsen der Verdampferschiffchen gegenüber der Laufrichtung (X) einen Winkel (α, α', β, β') einschließen,
- die Vorrichtung eine Einrichtung (12, 13) zur Zuführung von Draht eines zu verdampfenden Materials (14, 15) zu den Verdampferschiffchen (9, 9', 10, 10') aufweist,
**dadurch gekennzeichnet, dass** die Beschichtung mittels
- Verdampferschiffchen erfolgt, besagter Winkel (α, α', β, β') einen Absolutbetrag zwischen 2° und 10° aufweist,
- und die Verdampferschiffchen (9, 9', 10, 10') alternierend nebeneinander angeordnet sind, so dass ein Verdampferschiffchen (9, 9'), dessen Längsachsen entgegen dem Uhrzeigersinn gegenüber der Laufrichtung (X) gedreht ist, neben einem Verdampferschiffchen (10, 10') angeordnet wird, dessen Längsachse im Uhrzeigersinn gegenüber der Laufrichtung (X) gedreht ist.

12. Verfahren nach Anspruch 11, **dadurch gekennzeichnet, dass**
- die Dampfkeule eines einzelnen Verdampferschiffchens (9, 9', 10, 10') ein Dichtezentrum mit Schenkeln quer zur Längsachse des Verdampferschiffchens (9, 9', 10, 10') aufweist,
- die Verdampferschiffchen (9, 9', 10, 10') derart angeordnet werden, dass für eine Vielzahl von Verdampferschiffchen (9, 9', 10, 10') ein Schenkel ins Freie zeigt, während der andere Schenkel zwischen den Dichtezentren der benachbarten Verdampferschiffchen hindurch zeigt.

13. Verfahren nach Anspruch 11 oder 12, **dadurch gekennzeichnet, dass** die Winkel (α, a', β, β') in einer solchen Weise gewählt werden, dass die durch die Verdampferbank auf dem Substrat (8) bewirkte Beschichtung eine minimale Schichtdickenschwankung aufweist.

## Claims

1. Apparatus for coating a band-shaped substrate (8) which can be moved in a running direction (X) with respect to an evaporator bench,
- the evaporator bench having a number of heated evaporator saggars (9, 9', 10, 10'), the longitudinal axes of the evaporator saggars enclosing an angle (α, α', β, β') with respect to the running direction (X),
- the apparatus having a device (12, 13) for feeding wire of a material (14, 15) to be evaporated to the evaporator saggars (9, 9', 10, 10'),
**characterized in that**
- the said angle (α, α', β, β') having an absolute value between 2° and 10°,
- the evaporator saggars (9, 9', 10, 10') are arranged such that they alternate next to one another, with the result that an evaporator saggar (9, 9'), the longitudinal axis of which is rotated counter to the clockwise direction with respect to the running direction (X), is situated next to an evaporator saggar (10, 10'), the longitudinal axis of which is rotated in the clockwise direction with respect to the running direction (X).

2. Apparatus according to Claim 1, **characterized in that** the vapour jet of an individual evaporator saggar (9, 9', 10, 10') has a centre of density with flanks transversely with respect to the longitudinal axis of the evaporator saggar (9, 9', 10, 10'), and one flank points into the open for a multiplicity of evaporator saggars (9, 9', 10, 10'), whereas the other flank points between the centres of density of the adjacent evaporator saggars.

3. Apparatus according to one of the preceding claims, **characterized in that** the absolute values of the angles (α, α') of the evaporator saggars (9, 9') which are rotated counter to the clockwise direction or the absolute values of the angles (β, β') of the evaporator saggars (10, 10') which are rotated in the clockwise direction lie in a range between 3° and 10°.

4. Apparatus according to one of the preceding claims, **characterized in that** the absolute values of the angles (α, α', β, β') of all evaporator saggars (9, 9', 10, 10') lie in a range between 3° and 10°.

5. Apparatus according to one of the preceding claims, **characterized in that** the angles (α, α', β, β') of the evaporator saggars (9, 9', 10, 10') have the approximately identical absolute value.

6. Apparatus according to Claim 5, **characterized in that** the absolute values of the angles (α, α', β, β') of the evaporator saggars (9, 9', 10, 10') are approximately 5°.

7. Apparatus according to one of the preceding claims, **characterized**
- **in that** the evaporator saggars (9, 9') which are rotated counter to the clockwise direction are arranged within one strip (SA),
- **in that** the evaporator saggars (10, 10') which are rotated in the clockwise direction are arranged within one strip (SB),
- and **in that** the strips (SA, SB) have an overlapping zone (Z).

8. Apparatus according to Claim 7, **characterized in that** each strip (SA, SB) has a constant width (BA, BB).

9. Apparatus according to Claim 7 or 8, **characterized in that** the strips (SA, SB) are arranged perpendicularly with respect to the running direction (X).

10. Apparatus according to one of the preceding claims, **characterized in that** the angles (α, α', β, β') are selected in such a way that the coating which is brought about on the substrate (8) by the evaporator bench has a minimum layer-thickness deviation.

11. Method for coating a band-shaped substrate (8) which is moved in a running direction (X) with respect to an evaporator bench,
- the evaporator bench having a number of heated evaporator saggars (9, 9', 10, 10'), the longitudinal axes of the evaporator saggars enclosing an angle (α, α', β, β') with respect to the running direction (X),
- the apparatus having a device (12, 13) for feeding wire of a material (14, 15) to be evaporated to the evaporator saggars (9, 9', 10, 10'),
**characterized in that** the coating takes place by means of
- evaporator saggars, the said angle (α, α', β, β') having an absolute value between 2° and 10°,
- and the evaporator saggars (9, 9', 10, 10') are arranged such that they alternate next to one another, with the result that an evaporator saggar (9, 9'), the longitudinal axis of which is rotated counter to the clockwise direction with respect to the running direction (X), is situated next to an evaporator saggar (10, 10'), the longitudinal axis of which is rotated in the clockwise direction with respect to the running direction (X).

12. Method according to Claim 11, **characterized in that**
- the vapour jet of an individual evaporator saggar (9, 9', 10, 10') has a centre of density with flanks transversely with respect to the longitudinal axis of the evaporator saggar (9, 9', 10, 10'),
- the evaporator saggars (9, 9', 10, 10') are arranged in such a way that one flank points into the open for a multiplicity of evaporator saggars (9, 9', 10, 10'), whereas the other flank points between the centres of density of the adjacent evaporator saggars.

13. Method according to Claim 11 or 12, **characterized in that** the angles (α, α', β, β') are selected in such a way that the coating which is brought about on the substrate (8) by the evaporator bench has a minimum layer-thickness deviation.

## Revendications

1. Dispositif de revêtement d'un substrat en forme de bande (8) qui peut être déplacé dans une direction d'avance (X) par rapport à un banc de vaporisateurs, dans lequel
- le banc de vaporisateurs présente un certain nombre de nacelles de vaporisateur (9, 9', 10, 10') pouvant être chauffées, les axes longitudinaux des nacelles de vaporisateur formant un angle (α, α', β, β') avec la direction d'avance (X),
- le dispositif présente un système (12, 13) pour l'alimentation de fil métallique en matériau à vaporiser (14, 15) aux nacelles de vaporisateur (9, 9', 10, 10'),
**caractérisé en ce que**
- ledit angle (α, α', β, β') présente une valeur absolue comprise entre 2° et 10°,
- les nacelles de vaporisateur (9, 9', 10, 10') sont disposées en alternance les unes à côté des autres de telle sorte qu'une nacelle de vaporisateur (9, 9') dont l'axe longitudinal est tourné par rapport à la direction d'avance (X) dans le sens inverse des aiguilles d'une montre se trouve à côté d'une nacelle de vaporisateur (10, 10') dont l'axe longitudinal est tourné par rapport à la direction d'avance (X) dans le sens des aiguilles d'une montre.

2. Dispositif selon la revendication 1, **caractérisé en ce que** le nuage de vapeur d'une nacelle de vaporisateur individuelle (9, 9', 10, 10') présente un centre de densité avec des branches transversalement à l'axe longitudinal de la nacelle de vaporisateur (9, 9', 10, 10'), et pour une pluralité de nacelles de vaporisateur (9, 9', 10, 10'), une branche est dirigée à l'air libre, tandis que l'autre branche est dirigée entre les centres de densité des nacelles de vaporisateur adjacentes.

3. Dispositif selon l'une quelconque des revendications précédentes, **caractérisé en ce que** les valeurs absolues des angles (α, α') des nacelles de vaporisateur (9, 9') tournées dans le sens inverse des aiguilles d'une montre ou les valeurs absolues des angles (β, β') des nacelles de vaporisateur (10, 10') tournées dans le sens des aiguilles d'une montre se situent dans une plage comprise entre 3° et 10°.

4. Dispositif selon l'une quelconque des revendications précédentes, **caractérisé en ce que** les valeurs absolues des angles (α, α', β, β') de toutes les nacelles de vaporisateur (9, 9', 10, 10') se situent dans une plage comprise entre 3° et 10°.

5. Dispositif selon l'une quelconque des revendications précédentes, **caractérisé en ce que** les angles (α, α', β, β') des nacelles de vaporisateur (9, 9', 10, 10') ont approximativement la même valeur absolue.

6. Dispositif selon la revendication 5, **caractérisé en ce que** les valeurs absolues des angles (α, α', β, β') des nacelles de vaporisateur (9, 9', 10, 10') valent approximativement 5°.

7. Dispositif selon l'une quelconque des revendications précédentes, **caractérisé en ce que**
- les nacelles de vaporisateur (9, 9') tournées dans le sens inverse des aiguilles d'une montre sont disposées à l'intérieur d'une voie (SA),
- les nacelles de vaporisateur (10, 10') tournées dans le sens des aiguilles d'une montre sont disposées à l'intérieur d'une voie (SB),
- et les voies (SA, SB) présentent une zone de chevauchement (Z).

8. Dispositif selon la revendication 7, **caractérisé en ce que** chaque voie (SA, SB) présente une largeur constante (BA, BB).

9. Dispositif selon la revendication 7 ou 8, **caractérisé en ce que** les voies (SA, SB) sont disposées perpendiculairement à la direction d'avance (X).

10. Dispositif selon l'une quelconque des revendications précédentes, **caractérisé en ce que** les angles (α, α', β, β') sont choisis de telle sorte que le revêtement créé par le banc de vaporisateurs sur le substrat (8) présente une variation d'épaisseur de couche minimale.

11. Procédé de revêtement d'un substrat (8) en forme de bande, qui est déplacé dans une direction d'avance (X) par rapport à un banc de vaporisateurs, dans lequel
- le banc de vaporisateurs présente un certain nombre de nacelles de vaporisateur (9, 9', 10, 10') pouvant être chauffées, les axes longitudinaux des nacelles de vaporisateur formant un angle (α, α', β, β') avec la direction d'avance (X),
- le dispositif présente un système (12, 13) pour l'alimentation de fil métallique en matériau à vaporiser (14, 15) aux nacelles de vaporisateur (9, 9', 10, 10'),
- ledit angle (α, α', β, β') présente une valeur absolue comprise entre 2° et 10°,
- et les nacelles de vaporisateur (9, 9', 10, 10') sont disposées en alternance les unes à côté des autres de telle sorte qu'une nacelle de vaporisateur (9, 9') dont l'axe longitudinal est tourné par rapport à la direction d'avance (X) dans le sens inverse des aiguilles d'une montre se trouve à côté d'une nacelle de vaporisateur (10, 10') dont l'axe longitudinal est tourné par rapport à la direction d'avance (X) dans le sens des aiguilles d'une montre.

12. Procédé selon la revendication 11, **caractérisé en ce que**
- le nuage de vapeur d'une nacelle de vaporisateur individuelle (9, 9', 10, 10') présente un centre de densité avec des branches transversalement à l'axe longitudinal de la nacelle de vaporisateur (9, 9', 10, 10'),
- et les nacelles de vaporisateur (9, 9', 10, 10') sont disposées de telle sorte que pour une pluralité de nacelles de vaporisateur (9, 9', 10, 10'), une branche soit dirigée à l'air libre, tandis que l'autre branche est dirigée entre les centres de densité des nacelles de vaporisateur adjacentes.

13. Procédé selon la revendication 11 ou 12, **caractérisé en ce que** les angles (α, α', β, β') sont choisis de telle sorte que le revêtement créé par le banc de vaporisateurs sur le substrat (8) présente une variation d'épaisseur de couche minimale.
